**Europäisches Patentamt**

**European Patent Office**

**Office européen des brevets**

(19)

(11) Veröffentlichungsnummer : **0 453 582 B1**

(12) **EUROPÄISCHE PATENTSCHRIFT**

(45) Veröffentlichungstag der Patentschrift :
**11.01.95 Patentblatt 95/02**

(51) Int. Cl.⁶ : **H03H 17/02**

(21) Anmeldenummer : **90105499.9**

(22) Anmeldetag : **23.03.90**

(54) **Medianfilter.**

(43) Veröffentlichungstag der Anmeldung :
**30.10.91 Patentblatt 91/44**

(45) Bekanntmachung des Hinweises auf die
Patenterteilung :
**11.01.95 Patentblatt 95/02**

(84) Benannte Vertragsstaaten :
**DE FR GB IT NL**

(56) Entgegenhaltungen :
**EP-A- 0 257 843**
**IEEE TRANSACTIONS ON CIRCUITS AND SY-**
**STEMS, Band 35, Nr. 6, Juni 1988, Sei-**
**ten675-690, New York, US; H.-M. LIN et al.:**
**"Median filters with adaptive lenght"**

(73) Patentinhaber : **Deutsche ITT Industries GmbH**
**Hans-Bunte-Strasse 19**
**D-79108 Freiburg (DE)**

(72) Erfinder : **Mehrgardt, Sönke, Dr. rer. nat.**
**Häglestrasse 26**
**D-7806 March-Neuershausen (DE)**

## Beschreibung

Die Erfindung betrifft ein Medianfilter, durch das in einer Signalfolge ein Signal durch dasjenige ersetzt wird, das den mittleren wert (Median) in einer Signalgruppe darstellt, die durch das zu ersetzende Signal sowie N/2 unmittelbar vorher aufgetretener Signale und N/2 unmittelbar danach auftretender Signale gebildet wird, wobei N eine gerade ganze Zahl ist und den Grad des Filters angibt, bei dem die am Eingang eingehenden Signale an eine Kette von Verzögerungselementen gelangen, deren Zahl gleich dem Grad des Medianfilters ist, so daß bei Auftreten eines Signals am Eingang die N vorhergehenden Signale an den Ausgängen der Verzögerungselemente auftreten, und bei dem der Median aus der Signalgruppe in einer Auswahleinheit ermittelt und an den Ausgang des Medianfilters durchgeschaltet wird.

Ein Medianfilter sortiert demnach eine Anzahl von Signalen in der Reihenfolge ihrer Amplitudengröße und ersetzt den aktuellen Wert durch den mittleren Wert (Median) der sortierten Signalfolge. Medianfilter sind zeitdiskrete, nichtlineare Filter. Sie wurden schon mehrfach zur Verwendung bei Fernsehsignalen vorgeschlagen (vgl. P. Maragos, R.W. Schafer, "IEEE Trans. on Acoustics, Speech, and Signal Processing", Vol. ASSB-35, No. 8 (August 1987), S. 1170 bis 1183; A. Rosenfeld/A.C. Kak, "Digital Picture Processing", 2nd ed., Vol. 1 (1982), S. 261 bis 265; Schönfelder, "Digitale Filter in der Videotechnik" (1988), S. 125, 126, 224 bis 226). Sie haben die Eigenschaft, nur kurzzeitig auftretende Signaländerungen - also im Prinzip: Rauschen - zu unterdrücken, gleichzeitig jedoch länger anhaltende Veränderungen des Signalpegels, wie Stufen und Rampen ohne Verzerrung zu übertragen.

Bei der Ermittlung des mittleren Wertes (Median) der Signalfolge muß jeder Wert einer Signalgruppe mit jedem anderen Wert der Signalgruppen verglichen und die Ergebnisse dieser Vergleiche logisch verarbeitet werden. Dies ist schaltungsmäßig sehr aufwendig.

Aufgabe der Erfindung ist es, für einen Medianfilter der eingangs genannten Art eine vereinfachte Schaltung anzugeben.

Erfindungsgemäß wird dies dadurch gelöst, daß die an den Ausgängen der Verzögerungsglieder auftretenden N Signale, die dem am Eingang auftretenden Signal vorhergegangen sind, an N Subtrahierer gelangen, die die Differenzen des Signals am Eingang mit den vorher aufgetretenen N Signalen bilden, und daß die Vorzeichen der Differenzbildungen in Schieberegister gelangen, dort gespeichert und bei Auftreten eines neuen Signals am Eingang einen Platz weiter verschoben werden, so daß in den Schieberegistern auch die Vorzeichen der Vergleichsergebnisse zu den Zeitpunkten der N vorher aufgetretenen Signale, soweit sie zur Ermittlung des Medians der Signalgruppe in der Auswahleinheit erforderlich sind, gespeichert sind, wobei die Zahl der Speicherplätze jeweils entsprechend bestimmt ist, und daß die für die Ermittlung des Medians erforderlichen Vorzeichen der Differenzbildungen aus den Speicherplätzen der Schieberegister an die Auswahleinheit gelangen, der ein Multiplexer nachgeschaltet ist, an dem das am Eingang auftretende Signal und von den Ausgängen der Verzögerungselemente die N vorher aufgetretenen Signale anliegen, und daß in der Auswahleinheit aus den Vorzeichen der Vergleichsvorgänge der Median als dasjenige Signal bestimmt wird, für das die Vergleiche N/2 Ergebnisse mit negativen Vorzeichen und N/2 Ergebnisse mit positivem Vorzeichen ergeben haben, und daß die Auswahleinheit dann ein Signal an den Multiplexer abgibt, das den Median an den Ausgang durchschaltet.

Eine weitere Lösung sieht vor, daß die Verarbeitung der Signale mit einem Systemtakt erfolgt, der gleich dem N-fachen des Taktes des Auftretens der Signale am Eingang des Medianfilters ist, und daß der Eingang mittels eines Schalters jeweils bei erneutem Auftreten eines Signals am Eingang für die Dauer eines Systemtaktes mit einer Kette von N Verzögerungselementen verbunden wird, und daß während der restlichen Systemtakte der Schalter den Eingang des ersten Verzögerungselementes mit dem Ausgang des vorletzten Verzögerungselementes verbindet, und daß ferner der Ausgang des letzten Verzögerungselementes stets mit einem Eingang eines Subtrahierers verbunden ist, dessen anderer Eingang mit dem Eingang des Medianfilters verbunden ist, derart, daß im Subtrahierer während der N Takte zwischen dem Auftreten der Signale am Eingang die Differenzen des Signals am Eingang mit den vorher aufgetretenen N Signalen gebildet werden, und daß die Vorzeichen der Vergleichsergebnisse in einem Schieberegister mit (N+1)·N/2 Speicherplätzen gespeichert und je Systemtakt um einen Platz weiter verschoben werden, und daß die in den Speicherplätzen des Schieberegisters gespeicherten Vorzeichen der Vergleichsergebnisse an die Auswahleinheit gelangen, in der als Median dasjenige Signal festgestellt wird, für das die Vergleiche N/2 Ergebnisse mit negativem Vorzeichen und N/2 Ergebnisse mit positivem Vorzeichen ergeben haben, und daß der Auswahleinheit ein Multiplexer nachgeschaltet ist, an dem das am Eingang auftretende Signal und von den Ausgängen der Verzögerungselemente die N vorher aufgetretenen Signale anliegen, und daß die Durchschaltung eines der Signale an den Ausgang in Abhängigkeit von der Feststellung in der Auswahleinheit erfolgt.

Eine vorteilhafte Weiterbildung der Erfindung ist in Unteranspruch 2 definiert.

Die Erfindung kommt also mit einer vergleichsweise geringen Anzahl von Subtrahierern aus. Sie nutzt die

2

Erkenntnis, daß ein Teil der Differenzbildungen, die pro Signal der Signalfolge zur Bestimmung des Medians vorgenommen werden müssen, schon während des vorhergehenden Signals vorgenommen wurden bzw. auch bei der Ermittlung des Medians während des nachfolgenden Signals erneut vorgenommen werden müssen. Der Schaltungsaufbau wird daher unter Verwendung von Schieberegistern so getroffen, daß diese Subtraktionen nicht stets erneut vorgenommen werden müssen, sondern aus den bereits vorher stattgefundenen Vergleichen übernommen werden können. Die Bereitstellung der Ergebnisse der Differenzbildungen, die für die Ermittlung des Medians erforderlich sind, bzw. der Vorzeichen der Vergleichsergebnisse und deren zeitliche Zuordnung, erfolgt durch die Schieberegister, die den Subtrahierern nachgeschaltet sind.

Ausführungsbeispiele der Erfindung und ihrer vorteilhaften Weiterbildung werden im folgenden anhand der beigefügten Zeichnungen näher beschrieben. Es stellen dar:

Figur 1      ein Medianfilter nach dem Stande der Technik;

Figur 2      ein Ausführungsbeispiel der Erfindung für einen Medianfilter vom Grad 4;

Figur 2a      der Teil $AE_2$ der Auswerteeinheit AE nach Figur 2;

Figur 3      eine verallgemeinerte Darstellung des Ausführungsbeispiels nach Figur 2;

Figur 4      ein zweites Ausführungsbeispiel;

Figur 4a      eine tabellarische Darstellung der zeitlichen Aufeinanderfolge der Signale in Figur 4.

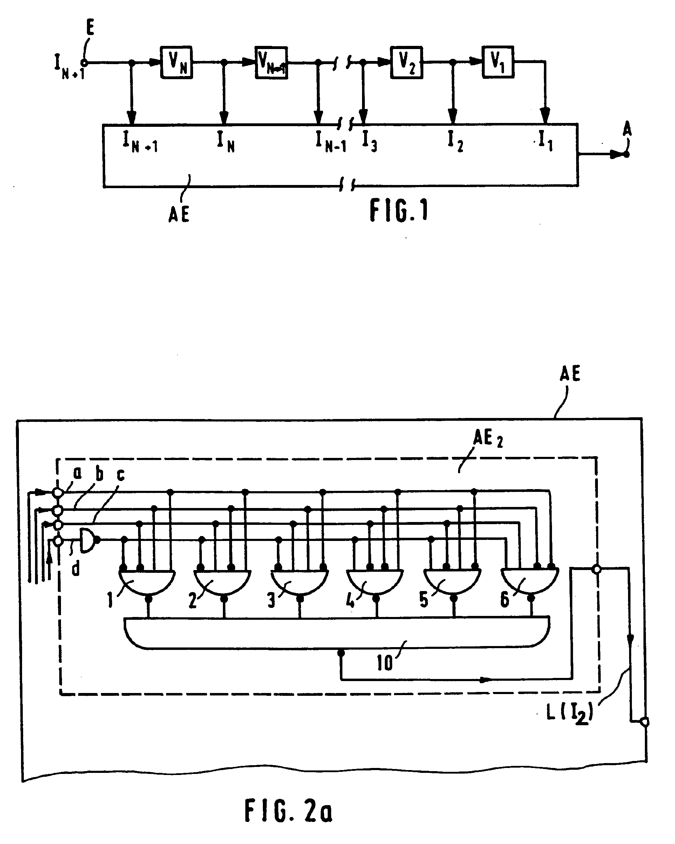

Figur 1 zeigt den prinzipiellen Aufbau eines bekannten Medianfilters des Grades N. Das am Eingang E auftretende Signal $I_{N+1}$ durchläuft nacheinander N Verzögerungselemente $V_N$, $V_{N-1}$, ..., $V_1$, so daß an den Ausgängen dieser Verzögerungselemente zum Zeitpunkt des Auftretens von $I_{N+1}$ die während der N vorhergehenden Signaltakte aufgetretenen Signale $I_N$, $I_{N-1}$, ..., $I_3$, $I_2$, $I_1$ zur Verfügung stehen. Diese Signale gelangen in eine Auswahleinheit AE, die den mittleren Wert ermittelt. Dieser "mittlere Wert" ist dadurch gekennzeichnet, daß er bei einer Sortierung der Signale $I_{N+1}$, $I_N$, ..., $I_1$ der Größe (Amplitude) nach der mittlere der Signale $I_{N+1}$, $I_N$, ..., $I_1$ (Signalgruppe) ist. Das ist dann der Fall, wenn von den anderen Signalen N/2 größer und N/2 Werte kleiner sind als der Median. Dieser Median gelangt dann als Ausgangssignal an dem Ausgang A der Auswahleinheit AE. In der Auswahleinheit AE müssen also die Wert $I_{N+1}$, $I_N$, ..., $I_1$ der Größe nach geordnet/sortiert werden; dann wird der mittlere Wert als Ausgangssignal durchgeschaltet.

Die folgenden Beispiele erläutern ein Medianfilter des Grades 2 (N=2):

(a)      Signalfolge am Eingang: 0, 0, 1, 0, 0 Es muß also jeder Wert durch den Median aus der Signalgruppe seiner selbst und seiner beiden Nachbarn ersetzt werden. Beim ersten Wert ("0") ist das noch nicht möglich, da kein linker Nachbar da ist. Bei der zweiten "0" ist der Median aus den 3 Werten "0, 0, 1" auch "0". Für den darauffolgenden Wert "1" ist der Median aus "0, 1, 0" zu bilden. Man erhält ebenfalls "0". Der vierte Wert ist der Median aus "1, 0, 0", also auch wiederum "0".

     Die Signalfolge am Ausgang ist: <u>0, 0, 0, 0, 0,</u>

     ....

     Ein Ausreißer, ein "Spike", wird also eliminiert.

(b)      Signalfolge am Eingang: <u>0, 0, 1, 1, 0, 0,</u> ...

     Signalfolge am Ausgang: <u>0, 0, 1, 1, 0, 0,</u> ...;

     die Folge bleibt also unverändert.

     Ein Rechteckimpuls (Stufe, Step) wird also unverändert übertragen.

(c)      Signalfolge am Eingang: <u>0, 0, 1, 2, 3, 4,</u> ...;

     Signalfolge am Ausgang: <u>0, 0, 1, 2, 3, 4,</u> ...;

     auch diese Folge, eine "Rampe", wird unverändert übertragen.

Medianfilter haben also die Eigenschaft, Spikes (=Rauschen) zu unterdrücken, hingegen Stufen oder steile Sprünge, die länger anhalten, unverändert zu übertragen. Das Filter kombiniert also im Ergebnis eine Rauschunterdrückung mit einer nur geringen Verschleifung von steilen Sprüngen.

Bei einem Medianfilter des Grades 4 (N=4) ist also jeweils aus einer Gruppe von 5 benachbarten Signalen der Median auszusortieren. Die Gruppe besteht aus einem Signal und seinen 2 zeitlich vorhergehenden und seinen 2 zeitlich nachfolgenden Signalen. Sie besteht also insgesamt aus 5 Signalen $I_5$, $I_4$, ..., $I_1$. Um nun jedes Signal mit jedem zu vergleichen und daraus den Median zu bestimmen, sind die folgenden Vergleiche erforderlich:

$$I_1-I_2, \quad I_2-I_3, \quad I_3-I_4, \quad I_4-I_5 \qquad 4 \text{ Vergleiche}$$

$$I_1-I_3, \quad I_2-I_4, \quad I_3-I_5, \qquad\qquad 3 \text{ Vergleiche}$$

$$I_1-I_4, \quad I_2-I_5 \qquad\qquad\qquad\qquad 2 \text{ Vergleiche}$$

$$I_1-I_5 \qquad\qquad\qquad\qquad\qquad\qquad \underline{1 \text{ Vergleich}}$$

$$10 \text{ Vergleiche}$$

Ergibt sich für einen der fünf zu vergleichenden Werte $I_i$, daß von den restlichen vier Werten zwei kleiner und zwei größer sind, so stellt dieser Wert den Median dar.

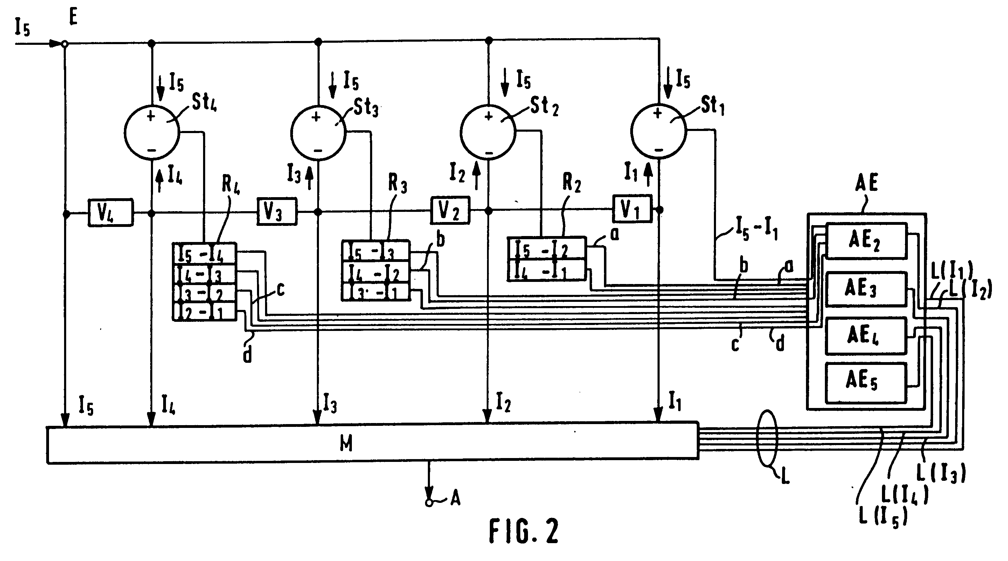

Figur 2 zeigt nun ein Ausführungsbeispiel für N=4. Die Schaltung sei zu einem Zeitpunkt betrachtet, in dem das 5-te Signal $I_5$ am Eingang E (M Bits parallel) anliegt. Es liegt direkt an den Subtrahierern $St_4$, $St_3$, $St_2$ und $St_1$ an, und zwar am jeweiligen Minuendeingang. An die jeweiligen Subtrahendeingänge dieser Subtrahierer gelangt das Signal vom Eingang E her jeweils über Verzögerungsschaltungen $V_4$, $V_3$, $V_2$, $V_1$, deren Verzögerungszeit gleich dem zeitlichen Abstand des Auftretens der Signale $I_i$, also gleich der Dauer der Signaltakte ist. Das bedeutet, daß an den jeweiligen Subtrahendeingängen der Subtrahierer $St_4$, $St_3$, $St_2$, $St_1$ nicht das Signal $I_5$, sondern dasjenige Signal anliegt, das eine entsprechende Anzahl von Signaltakten vorher am Eingang E gelegen hat. An $St_4$ liegen also zum Vergleich $I_5$ und $I_4$ an, an $St_3$ liegen $I_5$ und $I_3$ an; an $St_2$ liegen $I_5$ und $I_2$ an; an $St_1$ liegen $I_5$ und $I_4$ an. Die Subtrahierer führen die Subtraktion aus und geben das zum Sortieren (kleiner als, größer als) ausreichende Vorzeichen des Ergebnisses dieser Vergleiche über Ausgangsleitungen an nachgeschaltete Schieberegister $R_4$, $R_3$, $R_2$ weiter. Der Inhalt der Schieberegister wird jeweils pro Signaltakt um einen Speicherplatz weiter geschoben. Das bei N=4 vier Speicherplätze aufweisende Schieberegister $R_4$ enthält also zu dem Zeitpunkt, in dem am Eingang E $I_5$ anliegt, die Vorzeichen folgender Vergleiche:

Speicherplatz 1: $I_5-I_4$; Speicherplatz 2: $I_4-I_3$;
Speicherplatz 3: $I_3-I_2$; Speicherplatz 4: $I_2-I_1$.

Entsprechend enthalten die N-1=3 Speicherplätze des Schieberegisters $R_3$ die Vorzeichen folgender Vergleiche:

Speicherplatz 1: $I_5-I_3$; Speicherplatz 2: $I_4-I_2$;
Speicherplatz 3: $I_3-I_1$.

Die N-2=2 Speicherplätze des Schieberegisters $R_2$ enthalten Vorzeichen der Vergleiche $I_5-I_2$ und $I_4-I_1$.

Das Vorzeichen des Ergebnisses des Vergleiches $I_5-I_1$ am Ausgang von $St_1$ wird ohne Schieberegister direkt weiterverarbeitet. Hier wird beim Median aus $I_5$, ..., $I_1$ keiner der früher stattgefundenen Vergleiche benötigt. Ein Schieberegister kann also entfallen.

Indem man also 4 Verzögerungselemente verwendet, diese hintereinander schaltet und so abgreift, daß das am Eingang E der Schaltung anliegende Signal $I_5$ um 1, 2, 3 bzw. 4 Signaltakte verzögert wird, und die Ergebnisse des Vergleichs in Schieberegistern mit 4, 3 bzw. 2 Speicherplätzen speichert, kommt man mit nur 4 Subtrahiern aus, hat aber dennoch stets die Ergebnisse aller für die Ermittlung des Medians erforderlichen 10 Subtraktionsergebnisse zur Verfügung. Letzlich beruht das auf der Erkenntnis, daß je Signaltakt zu einem Teil Subtraktionen anfallen, die auch schon beim vorherigen Signaltakt angefallen sind. So ist im Zeitpunkt des Auftretens von $I_5$ das Ergebnis der Subtraktion $I_4-I_3$ gleich dem Ergebnis der Subtraktion $I_3-I_2$ im vorhergehenden Signaltakt, usw. Diese Ergebnisse werden in den Schieberegistern gespeichert und je Signaltakt um einen Platz weitergeschoben, so daß sich auf diese Weise eine Verringerung des Bedarfs an Subtraktionen pro Signaltakt ergibt.

Die Ergebnisse dieser 10 Vergleiche, die auf 4 parallelen Ausgängen der 4 Speicherplätze von Schieberegister $R_4$, 3 parallelen Ausgängen von Schieberegister $R_3$, 2 parallelen Ausgängen von Schieberegister $R_2$ und dem Ausgang von $St_1$ zur Verfügung stehen, gelangen an eine Auswahleinheit AE, die die Ermittlung des Medians vornimmt und je nach dem auf einer der 5 Leitungen $L(I_1)$, ..., $L(I_5)$ ein Signal an den Multiplexer M abgibt. Je nachdem, auf welcher der Leitungen ein Aktivierungssignal erfolgt ist, wird eines der Signale $I_5$, $I_4$, $I_3$, $I_2$, $I_1$ die auch direkt an M anliegen, an den Ausgang A durchgeschaltet.

Für die Sortierung der Signalwerte $I_5$, ..., $I_1$ und die Ermittlung des Medians braucht man nur die Vorzeichen der Differenzbildungen; es reicht also aus, in den Schieberegistern $R_4$, $R_3$, $R_2$ pro Speicherplatz nur 1 Vorzeichenbit vorzusehen.

Die Auswahleinheit AE muß eine Logik enthalten, um aus den in den Schieberegistern $R_4$, ..., $R_2$ bereit-

stehenden Vorzeichen der Ergebnisse der 10 Differenzbildungen $(l_j-l_i)$ zu ermitteln, welches der Signale $l_i$ dasjenige ist, daß der Median der Signalfolge $l_1, l_2, ..., l_5$ ist. Dies läßt sich in Form eines einfachen logischen Netzwerkes oder eines PLA (Programmed Logic Array) wie folgt realisieren:

Die Auswahleinheit AE ist in 4 Teilschaltungen $AE_2, AE_3, AE_4$ und $AE_5$ unterteilt. Diese sind den Signalen $l_2, l_3, l_4, l_5$ und den entsprechenden Leitungen $L(l_2), L(l_3), ..., L(l_5)$ jeweils zugeordnet. Eine entsprechende Teilschaltung für $l_1$ fehlt in Figur 2, obwohl sie im Prinzip vorhanden sein muß. Sie wird durch eine einfache (hier nicht weiter dargestellte) Schaltung verwirklicht, die die Leitung $L(l_1)$ immer dann aktiviert, wenn keine der anderen Leitungen $L(l_2), ..., L(l_5)$ aktiviert ist. Der besseren Übersichtlichkeit wegen sind ferner in Fig.2 innerhalb der Auswahleinheit AE lediglich die der Teilschaltung $AE_2$ zugeführten Leitungen a,b,c,d dargestellt.

Beispielhaft sei nun der für die Aktivierung von $l_2$ über Leitung $L(l_2)$ maßgebliche Teil $AE_2$ der Auswahleinheit AE anhand von Figur 2a erläutert:

Wie zunächst noch aus Figur 2 ersichtlich, erscheinen auf den Leitungen a, b, c, d diejenigen Vergleiche, an denen $l_2$ beteiligt ist. Ergibt sich bei zweien dieser Vergleiche, daß das Vorzeichen des Ergebnisses negativ ist ($l_2$ also größer als der Vergleichspartner ist) und bei zwei weiteren Vergleichen, daß das Vorzeichen des Ergebnisses positiv ist ($l_2$ also kleiner als der Vergleichspartner ist), dann ist $l_2$ der Median. Entsprechend ist die Schaltung nach Figur 2a aufgebaut. Dabei ist noch zu berücksichtigen, daß das Signal auf Leitung d zunächst invertiert wird, um aus dem Vorzeichen des Vergleiches $(l_2-l_1)$ das Vorzeichen des Vergleiches $(l_1-l_2)$ zu erhalten. Danach ergibt sich folgendes: Die NAND-Funktion an jedem der NAND-Verknüpfungsglieder 1, 2, 3, 4, 5, 6 ist erfüllt, wenn an allen 4 Eingängen eine "1" ansteht. Da zwei Eingänge invertiert sind, ist die NAND-Funktion an einem der NAND-Verknüpfungsglieder 1-6 erfüllt, wenn auf zwei der eingehenden Leitungen eine "1" steht (Ergebnis des Vergleichs positiv) und an den beiden invertierten Eingängen eine "0" (Ergebnis des Vergleichs negativ). Dann ist das Ausgangssignal einer der NAND-Verknüpfungsglieder eine "0". Wenn dies an einem der NAND-Verknüpfungsglieder der Fall ist, dann ist das Ausgangssignal des NAND-Verknüpfungsgliedes 10 eine "1", so daß die Leitung $L(l_2)$, die für die Aktivierung von $l_2$ vorgesehen ist, eine "1" führt.

Entsprechend sind die anderen Teile $AE_3, AE_4$ und $AE_5$ der Auswahleinheit AE ebenfalls aufgebaut.

Im einfachen Fall kann die Schaltung AE auch durch ein einfaches ROM (Read Only Memory) verwirklicht werden.

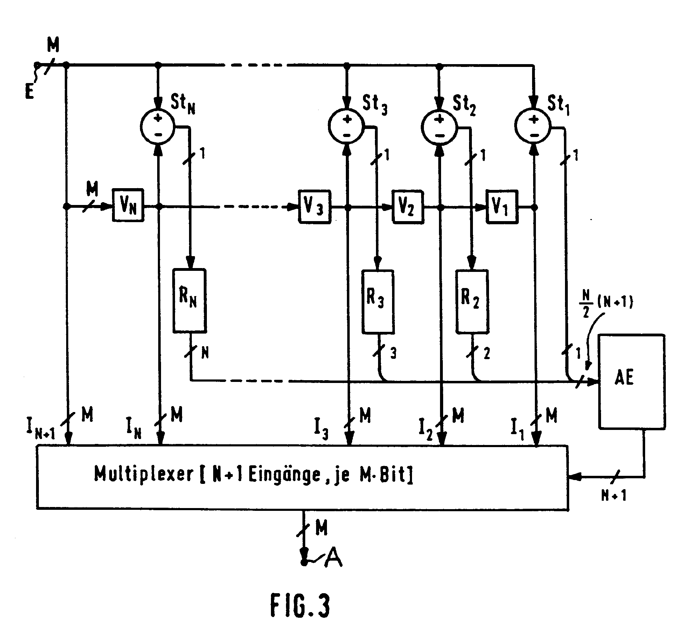

Figur 3 zeigt eine Verallgemeinerung der Schaltung nach Figur 2. Es sind N Subtrahierer, $St_N, ..., St_1$, N Verzögerungselemente $V_N, ..., V_1$ und N-1 Schieberegister $R_N, ..., R_2$ vorgesehen. Die Schieberegister werden seriell eingelesen; von jeder Stelle des Schieberegisters wird der Inhalt parallel ausgelesen. In Figur 3 bezeichnet dann jeweils ein kurzer Schrägstrich durch eine Leitung mit einer entsprechenden Zahlen- oder Buchstabenangabe, wieviele parallele Leitungen vorliegen. Im übrigen sind die Bezeichnungen dieselben wie in Figur 2.

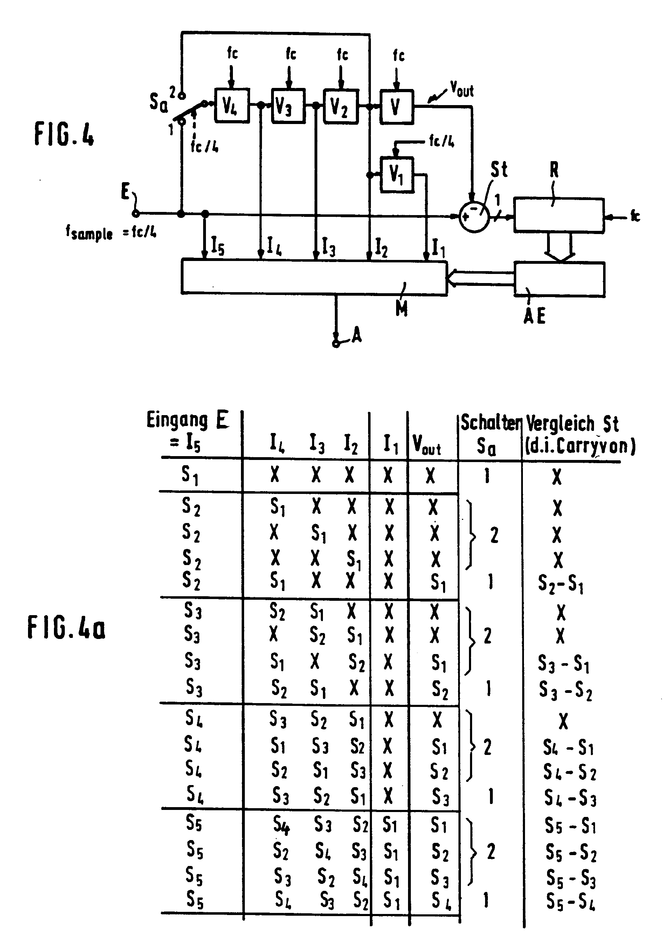

Figur 4 zeigt ein Ausführungsbeispiel mit serieller Verarbeitung am Beispiel eines Medianfilters des Grades N=4. Die System-Taktfrequenz $f_C$ beträgt das N-fache (also im Beispiel das 4-fache) der Abtastfrequenz $f_{Sample}$ der Signale am Eingang E.

Die Signaltakte sind mit $S_1, S_2 ..., S_5$ bezeichnet. Es sind die Abtastperioden der am Eingang eingehenden Signale, die jeweils zum Zeitpunkt ihres Auftretens an E mit $l_5$ bezeichnet sind. Ein Signaltakt $S_i$ (Frequenz$=f_{sample}$) umfaßt 4 Systemtakte (Frequenz$=f_C$).

Zunächst ist während des letzten zu $S_1$ gehörenden Systemtaktes ($f_c$) der Schalter $S_a$ in der unteren Stellung (= Position 1). $S_1$ gelangt an $V_4$. $V_4$ ist eines von 4 hintereinander angeordneten Verzögerungselementen $V_4, ..., V_1$ (bzw. V), die jeweils um die Periodendauer eines Systemtaktes verzögern.

Jetzt wird der Schalter $S_a$ nach oben gestellt (=Position 2). Das heißt, der Eingang von $V_4$ wird mit dem Ausgang von $V_2$ verbunden. Nach insgesamt 4 Systemtakten ($f_c$) gelangt $S_1$ an den Subtrahendeingang des Subtrahierers $S_t$. Nach diesen 4 Systemtakten hat aber auch wieder $S_a$ für die Periodendauer eines Systemtaktes nach unten umgeschaltet. Jetzt liegt an E, schon nunmehr seit 3 Systemtakten, $S_2$, an. An $S_t$ wird also $S_2-S_1$ gebildet. Ebenso wird nach jeweils weiteren 4 Systemtakten $S_3-S_2, S_4-S_3, S_5-S_4$ gebildet.

Während $S_a$ in der oberen Stellung war, also während 3 von 4 Systemtakten, sind in der von $V_4, V_3$ und $V_2$ gebildeten Schleife die Daten umgelaufen., d.h. dort um 3 Systemtakte (N-1) verzögert worden. $S_1$ liegt also 3 Systemtakte nach der Bildung von $(S_2-S_1)$ erneut an $S_t$ an. Am anderen Eingang von $S_t$ liegt dann aber bereits $S_2$, d.h. die Bildung der anderen Differenzen erfolgt analog. Die einzelnen Abläufe sind in einer Tabelle, Figur 4a dargestellt.

Ist der 5. Signaltakt $S_5$ 4 Systemtakte lang am Eingang E angelegen, so sind alle für N=4 erforderlichen Differenzbildungen, wie aus der rechten Spalte von Figur 4a ersichtlich, erfolgt, wobei zu diesem Zeitpunkt diese Differenzen den Differenzen $l_j-l_i$ nach den vorherigen Beispielen entsprechen. Die Vorzeichen dieser Differenzbildungen werden seriell in das Schieberegister R eingelesen.

Bei der in Fig.4 dargestellten Ankopplung des Schiebtaktes an den Systemtakt $f_c$ sind $N·(N+1)/2$ Speicherplätze im Schieberegister R erforderlich, denn der gesamte Datenzyklus zur Bestimmung des jeweiligen Medians umfaßt die gleiche Anzahl. Die Tabelle, Fig. 4a, zeigt einen Momentzustand zur Bestimmung eines Medians. Hierbei sind die Positionen x zwar ohne Bedeutung - ihr jeweiliger Zustand oder Vorzeichenwert ist jedoch für die Bestimmung eines der nachfolgenden Mediane von Bedeutuung.

Die Auswahleinheit AE und der Multiplexer M funktionieren auch in Fig. 4 wie in Fig. 2 und 3.

**Patentansprüche**

1. Medianfilter, durch das in einer Signalfolge ein Signal durch dasjenige ersetzt wird, das den mittleren Wert (Median) in einer Signalgruppe ($I_{N+1}$, $I_N$, ..., $I_1$) darstellt, die durch das zu ersetzende Signal sowie N/2 unmittelbar vorher aufgetretener Signale und N/2 unmittelbar danach auftretender Signale gebildet wird, wobei N eine gerade ganze Zahl ist und den Grad des Filters angibt, bei dem die am Eingang (E) eingehenden Signale an eine Kette von Verzögerungselementen ($V_N$, ..., $V_1$) gelangen, deren Zahl gleich dem Grad des Medianfilters ist, so daß bei Auftreten eines Signals ($I_{N+1}$) am Eingang (E) die N vorhergehenden Signale ($I_N$, ..., $I_1$) an den Ausgängen der Verzögerungselemente ($V_N$, ..., $V_1$) auftreten, und bei dem der Median aus der Signalgruppe ($I_{N+1}$, $I_N$, ..., $I_1$) in einer Auswahleinheit hat (AE) ermittelt und an den Ausgang (A) des Medianfilters durchgeschaltet wird, **dadurch gekennzeichnet**, daß die an den Ausgängen der Verzögerungsglieder ($V_N$, ..., $V_1$) auftretenden N Signale ($I_N$, ..., $I_1$), die dem am Eingang auftretenden Signal ($I_{N+1}$) vorhergegangen sind, an N Subtrahierer ($St_N$, ..., $St_1$) gelangen, die die Differenzen ($I_{N+1}$-$I_N$, $I_{N+1}$-$I_{N-1}$, ..., $I_{N+1}$-$I_1$) des Signals ($I_{N+1}$) am Eingang mit den vorher aufgetretenen N Signalen ($I_N$, ..., $I_1$) bilden, und daß die Vorzeichen der Differenz in Schieberegistern ($R_N$, ..., $R_2$) gelangen, gespeichert und bei Auftreten eines neuen Signals ($I_{N+1}$) am Eingang (E) einen Platz weiter verschoben werden, so daß in den Schieberegistern ($R_N$, ..., $R_2$) auch die Vorzeichen der Differenzen zu den Zeitpunkten der N vorher aufgetretenen Signale, soweit sie zur Ermittlung des Medians der Signalgruppe ($I_{N+1}$, ..., $I_1$) in der Auswahleinheit (AE) erforderlich sind, gespeichert sind, wobei die Zahl der Speicherplätze jeweils entsprechend bestimmt ist, und daß die für die Ermittlung des Medians erforderlichen Vorzeichen der Differenzen aus den Speicherplätzen der Schieberegister ($R_N$, ..., $R_2$) an die Auswahleinheit (AE) gelangen, der ein Multiplexer (M) nachgeschaltet ist, an dem das am Eingang (E) auftretende Signal ($I_{N+1}$) und von den Ausgängen der Verzögerungselemente ($V_N$, ..., $V_1$) die N vorher aufgetretenen Signale ($I_N$, ..., $I_1$) anliegen, und daß in der Auswahleinheit (AE) aus den Vorzeichen der Differenzen der Median als dasjenige Signal bestimmt wird, für das die Differenzen N/2 Ergebnisse mit negativem Vorzeichen und N/2 Ergebnisse mit positivem Vorzeichen ergeben haben, und daß die Auswahleinheit (AE) dann ein entsprechendes Steuer-Signal an den Multiplexer (M) abgibt, das den Median an den Ausgang (A) durchschaltet.

2. Medianfilter nach Anspruch 1, dadurch gekennzeichnet, daß die Auswahleinheit (AE) in Teilschaltungen ($AE_2$, $AE_3$, ..., $AE_5$) unterteilt ist, und in jeder Teilschaltung bezüglich eines der zur Signalgruppe gehörenden Signale durch ein logisches Netzwerk (1-6, 10) festgestellt wird, ob N/2 Differenzen positive Vorzeichen und N/2 Differenzen negative Vorzeichen haben, und bei Vorliegen dieser Funktion eine diesem Signal zugeordnete zum Multiplexer (M) führende Leitung (z.B. L($I_2$)) aktiviert wird.

3. Medianfilter, durch das in einer Signalfolge ein Signal durch dasjenige ersetzt wird, das den mittleren Wert (Median) in einer Signalgruppe ($I_{N+1}$, $I_N$, ..., $I_1$) darstellt, die durch das zu ersetzende Signal sowie N/2 unmittelbar vorher aufgetretener Signale und N/2 unmittelbar danach auftretender Signale gebildet wird, wobei N eine gerade ganze Zahl ist und den Grad des Filters angibt, bei dem die am Eingang (E) eingehenden Signale an eine Kette von Verzögerungselementen ($V_N$, ..., $V_1$) gelangen, deren Zahl gleich dem Grad des Medianfilters ist, so daß bei Auftreten eines Signals ($I_{N+1}$) am Eingang (E) die N vorhergehenden Signale ($I_N$, ..., $I_1$) an den Ausgängen der Verzögerungselemente ($V_N$, ..., $V_1$) auftreten, und bei dem der Median aus der Signalgruppe ($I_{N+1}$, $I_N$, ..., $I_1$) in einer Auswahleinheit hat (AE) ermittelt und an den Ausgang (A) des Medianfilters durchgeschaltet wird, dadurch gekennzeichnet, daß die Verarbeitung der Signale mit einem Systemtakt ($f_C$) erfolgt, dessen Frequenz gleich dem N-fachen des Signaltaktes ($f_{sample}$) ist, mit dem die Signale am Eingang (E) des Medianfilters auftreten, und daß der Eingang (E) mittels eines Schalters ($S_a$) jeweils bei erneutem Auftreten eines Signals am Eingang (E) für die Dauer einer Systemtakt-Periode mit einer Kette von N Verzögerungselementen ($V_N$, ..., $V_1$) verbunden wird, und daß während der restlichen Systemtakt-Perioden der Schalter ($S_a$) den Eingang des ersten Verzögerungselementes ($V_N$) mit dem Ausgang des vorletzten Verzögerungselementes ($V_2$) verbindet, und daß ferner der Ausgang des letzten Verzögerungselementes (V) stets mit dem Subtrahend-Eingang eines Subtrahierers (St) verbunden ist, dessen Minuend-Eingang mit dem Eingang (E) des Medianfilters verbunden ist, derart, daß im Subtrahierer (St) während der N Systemtakt-Perioden zwischen dem Auftreten der Signale am Eingang (E) die Differenzen des Signals ($I_{N+1}$) am Eingang mit den vorher aufgetretenen N Signalen ($I_N$, ...,$I_1$) gebildet werden, und daß die Vorzeichen der Diffenzen in einem Schieberegister (R) mit N·(N+1)/2 Plätzen gespeichert und je Systemtakt ($f_c$) um einen Platz weiter verschoben werden, und daß die in den Speicherplätzen des Schieberegisters (R) gespeicherten Vorzeichen der Vergleichsergebnisse an die Auswahleinheit (AE) gelangen, in der der Median als dasjenige Signal festgestellt wird, für das die Vergleiche N/2 Ergebnisse mit negativem Vorzeichen und N/2 Ergebnisse mit positivem Vorzeichen ergeben haben, und daß der Auswahleinheit (AE) ein Multiplexer (M) nachgeschaltet ist, an dem an das am Eingang auftretende Signal ($I_{N+1}$) und von den Ausgängen der Verzögerungselemente ($V_N$, ..., $V_1$) die N vorher aufgetretenen Signale ($I_N$, ..., $I_1$) anliegen, und daß die Durchschaltung eines dieser Signale an den Ausgang (A) in Abhängigkeit von der Feststellung in der Auswahleinheit (AE) erfolgt.

## Claims

1. Median filter by which a signal in a signal sequence is replaced by the signal representing the middle value (median) in a signal group ($I_{N+1}$, $I_N$, ..., $I_1$) which is formed by the signal to be replaced as well as N/2 signals having occurred immediately before and N/2 signals occurring immediately thereafter, where N is an even integer and specifies the degree of the filter, wherein the signals received at the input (E) are fed to a cascade of delay elements ($V_N$, ..., $V_1$) whose number is equal to the degree of the median filter, so that upon receipt of a signal ($I_{N+1}$) at the input (E), the N preceding signals ($I_N$, ..., $I_1$) appear at the outputs of the delay elements ($V_N$, ..., $V_1$), and wherein the median of the signal group ($I_{N+1}$, $I_N$, ..., $I_1$) is determined in a selection unit (AE) and switched to the output (A) of the median filter, characterized in that the N signals ($I_N$, ..., $I_1$) appearing at the outputs of the delay elements ($V_N$, ..., $V_1$) which preceded the signal ($I_{N+1}$) received at the input are fed to N subtracters ($St_N$, ..., $St_1$) which form the differences ($I_{N+1}$-$I_N$, $I_{N+1}$-$I_{N-1}$, ..., $I_N$+$_1$-$I_1$) between the signal ($I_{N+1}$) at the input and the N preceding signals ($I_N$, ..., $I_1$), that the signs of the differences are transferred into shift registers ($R_N$, ..., $R_2$) in which they are shifted by one place upon receipt of a new signal ($I_{N+1}$) at the input (E), so that the shift registers ($R_N$, .., $R_2$) also hold the signs of the differences at the instants of the N preceding signals as far as they are necessary to determine the median of the signal group ($_{N+1}$, ..., $I_1$) in the selection unit (AE), the number of memory locations being determined by the number of signs to be stored, that the signs of the differences required to determine the median are transferred from the memory locations of the shift registers ($R_N$, ..., $R_2$) into the selection unit (AE), which is followed by a multiplexer (M) which is fed with the signal ($I_{N+1}$) received at the input (E) and with the N preceding signals ($I_N$, ..., $I_1$) from the outputs of the delay elements ($V_N$, ..., $V_1$), that the selection unit (AE) determines from the signs of the differences the median as that signal for which N/2 differences have negative signs and N/2 differences have positive signs, and that the selection unit (AE) then provides to the multiplexer (M) a corresponding control signal which switches the median to the output (A).

2. A median filter as claimed in claim 1, characterized in that the selection unit (AE) is divided into subcircuits ($AE_2$, $AE_3$, ..., $AE_5$), that in each subcircuit, a logic network (1-6, 10) determines for one of the signals of the signal group whether N/2 differences have positive signs and N/2 differences have negative signs, and that if this condition is satisfied, a line (e.g., L($I_2$)) assigned to said signal and running to the multiplexer (M) will be activated.

3. A median filter by which a signal in a signal sequence is replaced by the signal representing the middle value (median) in a signal group ($I_{N+1}$, $I_N$, ..., $I_1$) which is formed by the signal to be replaced as well as N/2 signals having occurred immediately before and N/2 signals occurring immediately thereafter, where N is an even integer and specifies the degree of the filter, wherein the signals received at the input (E) are fed to a cascade of delay elements ($V_N$, ..., $V_1$) whose number is equal to the degree of the median filter, so that upon receipt of a signal ($I_{N+1}$) at the input (E), the N preceding signals ($I_N$, ..., $I_1$) appear at the outputs of the delay elements ($V_N$, ..., $V_1$), and wherein the median of the signal group ($I_{N+1}$, $I_N$, ..., $I_1$) is determined in a selection unit (AE) and switched to the output (A) of the median filter, characterized in that the signals are processed at a system clock rate ($f_C$) equal to N times the rate ($f_{sample}$) at which the signals appear at the input (E) of the median filter, that upon receipt of each signal at the input (E), the input (E) is connected by means of a switch ($S_a$) to a cascade of N delay elements ($V_N$, ..., $V_1$) for the duration of one system clock period, that during the remaining system clock periods, the switch ($S_a$) connects the input of the first delay element ($V_N$) to the output of the next to the last delay element ($V_2$), that the

output of the last delay element (V) is constantly connected to the subtrahend input of a subtracter (St) having its minuend input connected to the input (E) of the median filter, such that during the N system clock periods between the receipt of the signals at the input (E), the subtracter (St) forms the differences between the signal ($I_{N+1}$) at the input and the N preceding signafs ($I_N$, ..., $I_1$), that the signs of the differences are stored in a shift register (R) having N · (N + 1)/2 tions and are shifted one place by each system clock pulse ($f_c$), that the signs stored in the memory locations of the shift register (R) are transferred to the selection unit (AE), in which the median is determined as that signal for which N/2 differences have negative signs and N/2 differences have positive signs, that the selection unit (AE) is followed by a multiplexer (M) which is fed with the signal ($I_{N+1}$) received at the input and with the N preceding signals ($I_N$, ..., $I_1$) from the outputs of the delay elements ($V_N$, ..., $V_1$), and that one of said signals is switched to the output (A) in dependence on the determination made in the selection unit (AE).

**Revendications**

1. Filtre de séparation de la médiane, qui permet, dans une suite de signaux, de remplacer un signal par le signal qui représente la valeur moyenne (médiane) dans un groupe de signaux ($I_{N+1}$, $I_N$,...$I_1$), qui est formé par le signal à remplacer ainsi que par N/2 signaux apparus juste auparavant et par N/2 signaux apparus juste après, N étant un nombre entier pair et représentant le degré du filtre, et dans lequel les signaux arrivant à l'entrée (E) parviennent à une chaîne d'éléments de retardement ($V_N$,..., $V_1$), dont le nombre est égal au degré du filtre de séparation de la médiane, de sorte que lors de l'apparition d'un signal ($I_{N+1}$) à l'entrée (E), les N signaux précédents ($I_N$...$I_1$) apparaissent sur les sorties des éléments de retardement ($V_N$,...,$V_1$), et dans lequel la médiane est déterminée à partir du groupe de signaux ($I_{N+1}$, $I_N$, ..., $I_1$) dans une unité de sélection (AE) et est transmise à la sortie (A) du filtre de séparation de la médiane, <u>caractérisé en ce que</u> les N signaux ($I_N$, ..., $I_1$), qui apparaissent sur les sorties des circuits de retardement ($V_N$,...,$V_1$) et qui ont précédé le signal ($I_{N+1}$) apparu à l'entrée, parviennent à N soustracteurs ($St_N$,...,$St_1$), qui forment les différences ($I_{N+1}$-$I_N$, $I_{N+1}$-$I_{N-1}$,..., $I_{N+1}$-$I_l$) entre le signal ($I_{N+1}$) présent à l'entrée et les N signaux ($I_N$,...,$I_1$) apparus auparavant, et que les signes de la différence parviennent dans des registres à décalage ($R_N$,...,$R_2$), sont mémorisés et, lors de l'apparition d'un nouveau signal ($I_{N+1}$) à l'entrée (E), sont décalés en supplément d'une place, de sorte que dans les registres à décalage ($R_N$,...,$R_2$) sont également mémorisés des signes des différences aux instants des N signaux apparus antérieurement, dans la mesure où ils sont nécessaires pour la détermination de la médiane du groupe de signaux ($I_{N+1}$,...,$I_1$) dans l'unité de sélection (AE), le nombre des emplacements de mémoire étant déterminé de façon correspondante, et que les signes, qui sont nécessaires pour la détermination de la médiane, des différences parviennent depuis les emplacements de mémoire des registres à décalage ($R_N$,...,$R_2$) à l'unité de sélection (AE), en aval de laquelle est branché un multiplexeur (M), auquel parviennent le signal ($I_{N+1}$) apparaissant à l'entrée (E) et les N signaux ($I_N$,...,$I_1$) apparus antérieurement et provenant des sorties des éléments de retardement ($V_N$,..., $V_1$), et que dans l'unité de sélection (AE), la médiane est déterminée, à partir des signes des différences, en tant que signal pour lequel les différences ont fourni N/2 résultats avec un signe négatif et N/2 résultats avec un signe positif, et que l'unité de sélection (AE) délivre alors un signal de commande correspondant au multiplexeur (M), qui transfère la médiane à la sortie (A).

2. Filtre de séparation de la médiane selon la revendication 1, caractérisé en ce que l'unité de sélection (AE) est subdivisée en circuits partiels ($AE_2$, $AE_3$, ..., $AE_5$) et que dans chaque circuit partiel une détermination est faite en ce qui concerne l'un des signaux associés appartenant au groupe de signaux, au moyen d'un réseau logique (1-6,10), pour déterminer si N/2 différences possèdent des signes positifs et si N/2 différences possèdent des signes négatifs, et dans le cas de la présence de cette fonction, une ligne (par exemple L ($I_2$)), qui est associée à ce signal et aboutit au multiplexeur (M), est activée dans le cas de la présence de cette fonction.

3. Filtre de séparation de la médiane, qui permet, dans une suite de signaux, de remplacer un signal par le signal qui représente la valeur moyenne (médiane) dans un groupe de signaux ($I_{N+1}$, $I_N$,...$I_1$), qui est formé par le signal à remplacer ainsi que par N/2 signaux apparus juste auparavant et par N/2 signaux apparus juste après, N étant un nombre entier pair et représentant le degré du filtre, et dans lequel les signaux arrivant à l'entrée (E) parviennent à une chaîne d'éléments de retardement ($V_N$,..., $V_1$), dont le nombre est égal au degré du filtre de séparation de la médiane, de sorte que lors de l'apparition d'un signal ($I_{N+1}$) à l'entrée (E), les N signaux précédents ($I_N$...$I_1$) apparaissent sur les sorties des éléments de retardement ($V_N$,...,$V_1$), et dans lequel la médiane est déterminée à partir du groupe de signaux ($I_{N+1}$, $I_N$, ..., $I_1$) dans

une unité de sélection (AE) et est transmise à la sortie (A) du filtre de séparation de la médiane, <u>carac-</u><u>térisé en ce que</u> le traitement des signaux s'effectue avec une cadence ($f_C$) du système, dont la fréquence est égale à N fois la cadence ($f_{sample}$), avec laquelle les signaux apparaissent à l'entrée (E) du filtre de séparation de la médiane, et que l'entrée (E) est reliée au moyen d'un commutateur ($S_a$), respectivement lors d'une nouvelle apparition du signal à l'entrée (E), pendant la durée d'une période de la cadence du système, à une chaîne comportant N éléments de retardement ($V_N,...,V_1$), et que pendant les autres périodes de la cadence du système, le commutateur ($S_a$) relie l'entrée du premier élément de retardement ($V_N$) à la sortie de l'avant-dernier élément de retardement ($V_2$), et qu'en outre la sortie du dernier élément de retardement (V) est reliée en permanence à l'entrée du nombre à soustraire d'un soustracteur ($S_t$), dont l'entrée du minuende est reliée à l'entrée (E) du filtre de séparation de la médiane de telle sorte que dans le soustracteur ($S_t$), pendant les N périodes de la cadence du système, entre les apparitions des signaux à l'entrée (E), les différences entre le signal ($I_{N+1}$) apparaissant à l'entrée et les N signaux apparus antérieurement ($I_N,..., I_1$) sont formées et que les signes des différences sont mémorisés dans un registre à décalage (R) comportant N.(N+1)/2 emplacements et sont avancés d'un emplacement, sur la base de la cadence ($f_c$) du système, et que les signes, qui sont mémorisés aux emplacements de mémoire du registre à décalage (R), des résultats de comparaison parviennent à l'unité de sélection (AE), dans laquelle la médiane est fixée en tant que signal, pour lequel les comparaisons ont fourni N/2 résultats avec un signe négatif et N/2 résultats avec un signe positif, et qu'en aval de l'unité de sélection (AE) est branché un multiplexeur (M), auquel sont appliqués le signal ($I_{N+1}$) apparaissant à l'entrée et les N signaux apparus précédemment ($I_N,...,I_1$), qui proviennent des sorties des éléments de retardement ($V_N,...,V_1$), et que la transmission de l'un de ces signaux à la sortie (A) s'effectue en fonction de la détermination faite dans l'unité de sélection (AE).

FIG.1

FIG. 2a

FIG. 2

EP 0 453 582 B1

FIG.3

FIG.4

FIG.4a

| Eingang E = $I_5$ | $I_4$ | $I_3$ | $I_2$ | $I_1$ | $V_{out}$ | Schalter $S_a$ | Vergleich St (d.i.Carryvon) |
|---|---|---|---|---|---|---|---|
| $S_1$ | X | X | X | X | X | 1 | X |
| $S_2$ | $S_1$ | X | X | X | X | } 2 | X |
| $S_2$ | X | $S_1$ | X | X | X | | X |
| $S_2$ | X | X | $S_1$ | X | X | | X |
| $S_2$ | $S_1$ | X | X | X | $S_1$ | 1 | $S_2 - S_1$ |
| $S_3$ | $S_2$ | $S_1$ | X | X | X | } 2 | X |
| $S_3$ | X | $S_2$ | $S_1$ | X | X | | X |
| $S_3$ | $S_1$ | X | $S_2$ | X | $S_1$ | | $S_3 - S_1$ |
| $S_3$ | $S_2$ | $S_1$ | X | X | $S_2$ | 1 | $S_3 - S_2$ |
| $S_4$ | $S_3$ | $S_2$ | $S_1$ | X | X | } 2 | X |
| $S_4$ | $S_1$ | $S_3$ | $S_2$ | X | $S_1$ | | $S_4 - S_1$ |
| $S_4$ | $S_2$ | $S_1$ | $S_3$ | X | $S_2$ | | $S_4 - S_2$ |
| $S_4$ | $S_3$ | $S_2$ | $S_1$ | X | $S_3$ | 1 | $S_4 - S_3$ |
| $S_5$ | $S_4$ | $S_3$ | $S_2$ | $S_1$ | $S_1$ | } 2 | $S_5 - S_1$ |
| $S_5$ | $S_2$ | $S_4$ | $S_3$ | $S_1$ | $S_2$ | | $S_5 - S_2$ |
| $S_5$ | $S_3$ | $S_2$ | $S_4$ | $S_1$ | $S_3$ | | $S_5 - S_3$ |
| $S_5$ | $S_4$ | $S_3$ | $S_2$ | $S_1$ | $S_4$ | 1 | $S_5 - S_4$ |